# EUROPEAN PATENT APPLICATION

(11) **EP 4 339 748 A1**
(43) Date of publication of application: **20.03.2024**
(21) Application number: 22806681.7
(22) Date of filing: 09.05.2022
(51) Int. Cl.: G06F 3/041

(54) **TOUCH DETECTION METHOD AND APPARATUS FOR STEERING WHEEL**

(30) Priority: 10.05.2021 CN 202110505610
(71) Applicant: Valeo Interior Controls (Shenzhen) Co., Ltd., Shenzhen, Guangdong 518128 (CN)
(72) Inventor: HE, Chuan, Shenzhen, Guangdong 518128 (CN)
(74) Representative: Pothmann, Karsten
(86) International application number: PCT/CN2022/091662
(87) International publication number: WO 2022/237716

(57) **Abstract**

Provided are a method and apparatus for steering wheel touch detection, the steering wheel comprising at least one touch detection region, and at least one touch detection sensor being provided in each touch detection region. The method comprises: for each touch detection region, generating multiple reference signals which correspond to multiple specific frequencies on a one-to-one basis; respectively applying each reference signal to a touch detection sensor in the touch detection region, and acquiring each touch detection signal under each reference signal from the touch detection sensor; acquiring a measurement value of each touch detection signal; according to the measurement values of the touch detection signals, determining touch detection states respectively corresponding to each touch detection signal; and on the basis of the number of various touch detection states in the touch detection states corresponding to each touch detection signal, determining the touch state of this touch detection region of the steering wheel, wherein the touch states comprise a non-hands-off state, a hands-off state and an invalid state.

## Description

### Technical Field

The present invention relates to the field of motor vehicles, and more specifically, relates to a touch detection method and apparatus for a steering wheel.

### Background Art

Presently, in the field of motor vehicles, especially in the field of road vehicles, increasingly more autonomous driving technology is put into use to improve the comfort and safety of driving. Steering wheel touch detection has an increasingly important role in driving safety judgments of motor vehicles and autonomous control processes of motor vehicles, and therefore steering wheel touch detection also faces higher requirements.

At present, in the steering wheel touch detection process, generally at a single frequency, a touch sensor is used to sense a reference signal at this frequency, and a modulated touch detection signal (a modulated signal) is obtained at an output end of the sensor, then the modulated touch detection signal is demodulated to acquire a touch detection signal of the sensor, and a touch state of the steering wheel is determined according to the touch detection signal. However, in a situation in which a reference signal is only sensed at a single frequency, since electromagnetic interference is present in the detection environment, when this monofrequency reference signal is affected by electromagnetic interference, this directly causes system performance to massively drop, such that the touch detection system cannot implement the touch detection process or outputs erroneous signals, and thus the steering wheel touch state cannot be determined or is erroneously determined. This greatly affects subsequent control processes of the motor vehicle, reducing the reliability of the motor vehicle.

Therefore, a method is required which, on the basis of implementing steering wheel touch detection, can effectively reduce the influence of electromagnetic interference in the environment on the steering wheel touch detection process, increasing the accuracy and robustness of steering wheel touch detection, and this method for steering wheel touch detection has good flexibility and reliability.

### Summary of the Invention

To solve the technical problem described above, the present disclosure provides a method for steering wheel touch detection and an apparatus for steering wheel touch detection. Using the method for steering wheel touch detection provided by the present disclosure, on the basis of implementing steering wheel touch detection well, the accuracy of steering wheel touch detection may be effectively increased, real-time and high-precision steering wheel touch detection is achieved, and the method has good robustness.

In the sense of the present invention, the motor vehicle may be any vehicle. Preferably, the motor vehicle is, for example, a road vehicle or a train. Particularly preferably, the motor vehicle is a road vehicle, such as a passenger vehicle or a truck.

According to the vehicle, the steering wheel may correspondingly, for example, be a mechanical steering wheel, electronic steering wheel, joystick or control panel.

One aspect of the present disclosure relates to a method for steering wheel touch detection, wherein the steering wheel comprises at least one touch detection region, at least one touch detection sensor is provided in each touch detection region, and the method comprises: for each touch detection region, generating multiple reference signals corresponding to multiple specific frequencies on a one-to-one basis; applying each reference signal in the multiple reference signals respectively to the touch detection sensor in the touch detection region, and acquiring each touch detection signal under each reference signal from the touch detection sensor; acquiring a measurement value of each touch detection signal; determining touch detection states respectively corresponding to each touch detection signal, according to the measurement value of each touch detection signal, wherein the measurement values of the touch detection signals respectively correspond to a non-hands-off state, hands-off state and invalid state, acting as touch detection states, when respectively in a first threshold range, a second threshold range and a third threshold range; and on the basis of the number of the various touch detection states in the touch detection states corresponding to each touch detection signal, determining the touch state of the touch detection region of the steering wheel, the touch states comprising the non-hands-off state, hands-off state and invalid state.

Another aspect of the present disclosure relates to an apparatus for steering wheel touch detection, wherein the steering wheel comprises at least one touch detection region, at least one touch detection sensor is provided in each touch detection region, and the apparatus comprises: a signal generator, which is configured to generate multiple reference signals corresponding to multiple specific frequencies on a one-to-one basis; a signal detector, which is configured, for each touch detection region, to apply each reference signal in the multiple reference signals respectively to the touch detection sensor in the touch detection region, and acquire each touch detection signal under each reference signal from the touch detection sensor; and a signal processor, which is configured: to acquire a measurement value of each touch detection signal; to determine touch detection states respectively corresponding to each touch detection signal, according to the measurement value of each touch detection signal, wherein the measurement values of the touch detection signals respectively correspond to a non-hands-off state, hands-off state and invalid state, acting as touch detection states, when respectively in a first threshold range, a second threshold range and a third threshold range; and on the basis of the number of the various touch detection states corresponding to each touch detection signal, to determine the touch state of the touch detection region of the steering wheel, the touch states comprising the non-hands-off state, hands-off state and invalid state.

By using the method and apparatus for steering wheel touch detection provided by the present disclosure, wherein reference signals of different frequencies are applied to a touch detection sensor arranged on a steering wheel, the touch detection sensor may be caused to generate touch detection signals at each frequency, on the basis of the reference signals of different frequencies, to improve the capability of steering wheel touch detection to resist electromagnetic interference in the usage environment; and on the basis of a voting mechanism, voting is performed on touch detection states indicated by each touch detection signal of the touch detection sensor, thereby determining the touch state of the steering wheel, so as to further improve the accuracy and flexibility of touch detection, and therefore the influence of electromagnetic interference in the environment on the steering wheel touch detection process can be effectively reduced, improving the precision and robustness of steering wheel touch detection.

### Brief Description of the Drawings

In order to explain the technical solutions of embodiments of the present disclosure more clearly, drawings required for describing the embodiments are briefly described below. Obviously, the drawings in the description below are merely some exemplary embodiments of the present disclosure, and those skilled in the art could obtain other drawings based on these drawings without expending inventive effort.
Figs. 1A - 1B show schematic drawings of a steering wheel according to embodiments of the present disclosure.
Fig. 2A shows an illustrative flowchart of a method for steering wheel touch detection according to an embodiment of the present disclosure.
Figs. 2B - 2C show schematic drawings of processes of the steps in Fig. 2A.
Fig. 2D shows a timing schematic drawing of the reference signals in Fig. 2B applied to a touch detection sensor without temporal overlap.
Fig. 2E shows a schematic drawing of a correspondence between measurement values of touch detection signals and touch detection states according to an embodiment of the present disclosure.
Fig. 3 shows another illustrative flowchart of a method for steering wheel touch detection according to an embodiment of the present disclosure.
Fig. 4 shows a flowchart of a method for steering wheel touch detection, regarding a specific example, according to an embodiment of the present disclosure.
Figs. 5A - 5B show illustrative block diagrams of an apparatus for steering wheel touch detection according to embodiments of the present disclosure.

### Specific Embodiments

In order to make the objectives, technical solutions and advantages of the present disclosure clearer, the exemplary embodiments according to the present disclosure are described in detail below with reference to the accompanying drawings. Obviously, the described embodiments are merely some, rather than all, of the embodiments of the present disclosure; it should be understood that the present disclosure is not limited to the exemplary embodiments described herein.

In the specification and the accompanying drawings, substantially the same or similar steps and elements are denoted using the same or similar reference numerals, and repeated descriptions of these steps and elements are omitted. Moreover, in the descriptions of the present disclosure, terms such as "first" and "second" are merely used for distinguishing descriptions, and cannot be understood to indicate or imply relative importance or order.

It should be understood that the steering wheel touch detection of the present disclosure refers to a process for touch detection of a motor vehicle steering wheel, and the touch detection process is aimed at detecting a touch state between a driver's hands and the steering wheel of a motor vehicle.

As described above, at present, in the steering wheel touch detection process, generally at a single frequency, a touch sensor is used to sense a reference signal at this frequency, and a modulated touch detection signal is obtained at an output end of the sensor, then the modulated touch detection signal is demodulated to acquire a touch detection signal of the sensor, and a touch state of the steering wheel is determined according to the touch detection signal. However, in a situation in which a reference signal is only sensed at a single frequency, since electromagnetic interference is present in the detection environment, when this monofrequency reference signal is affected by electromagnetic interference, this directly causes system performance to massively drop, such that the touch detection system cannot implement the touch detection process or outputs erroneous signals, and thus the steering wheel touch state cannot be determined or is erroneously determined. This greatly affects subsequent control processes of the motor vehicle, reducing the reliability of the motor vehicle.

Based on the above, the present disclosure proposes a method for steering wheel touch detection. The steering wheel is provided with at least one touch detection sensor. Each touch detection sensor is used for generating corresponding modulated touch detection signals according to different reference signals applied at different frequencies, , and, on the basis of a voting mechanism, the touch detection signals, after demodulation, are used to implement steering wheel touch detection.

Firstly, the structure of a steering wheel involved in embodiments of the present disclosure is described simply.

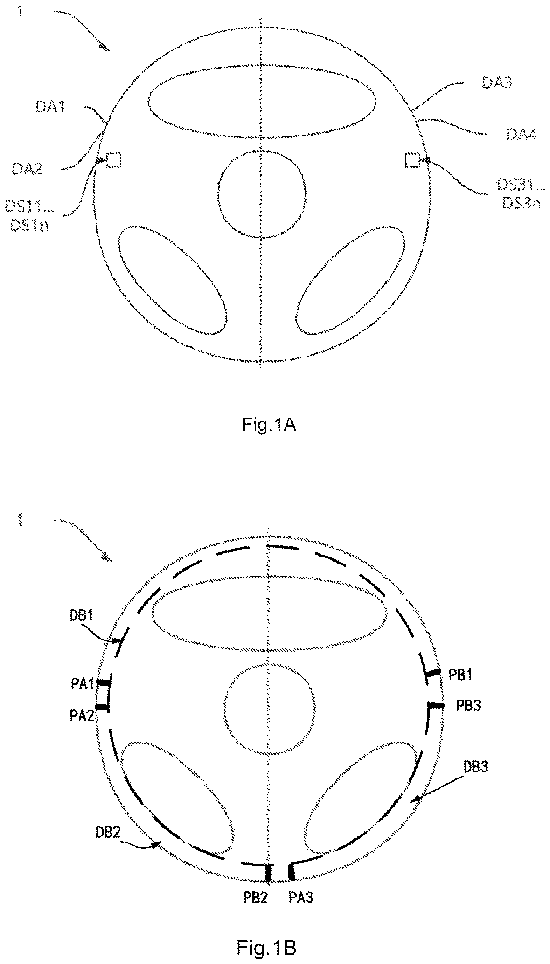

Figs. 1A - 1B show schematic drawings of a steering wheel according to embodiments of the present disclosure.

As shown in Fig. 1A, when touch detection is performed on the steering wheel, according to actual requirements, it is necessary to arrange at least one touch detection region on the steering wheel to ascertain whether different parts (for example, the left hand or right hand) of the driver are touching the steering wheel. According to an embodiment of the present invention, as shown by the dotted lines in Fig. 1, the steering wheel is illustratively partitioned into four touch detection regions, that is, a steering wheel left-front touch detection region (DA1), a steering wheel left-back touch detection region (DA2), a steering wheel right-front touch detection region (DA3) and a steering wheel right-back touch detection region (DA4). According to actual requirements, the steering wheel may be partitioned in any way into any number of touch detection regions at any positions as required, and there is no limitation to partitioning into the four touch detection regions as shown in this embodiment. In a specific example, just one touch detection region may be provided for the steering wheel, that is, a touch detection sensor arranged in this touch detection region can detect touch at any position on the steering wheel.

Fig. 1A shows multiple touch detection sensors (DS11... DS1n) at specific positions in the steering wheel left-front touch detection region (DA1) and multiple touch detection sensors (DS31... DS3n) for the steering wheel right-front touch detection region DA3. By means of redundantly arranging multiple touch detection sensors at the same specific position, even if one of the touch detection sensors therein experiences a fault, for example, and cannot work normally, the other touch detection sensors of the detection region can still work normally, and thereby receive the applied reference signal of each frequency, and modulate the reference signals and generate modulated touch detection signals, that is, the other touch detection sensors can provide accurate valid information for the final determination of the touch state, and thereby may effectively increase the reliability of touch detection.

It should be noted that although Fig. 1A shows one or more touch detection sensors arranged at specific positions for each detection region, the touch detection sensor may also, for example, have the form of a flexible touch mat, which may be arranged along the steering wheel. As shown in Fig. 1B, three touch detection regions (DB1 - DB3) are provided on the steering wheel, and each touch detection region is provided with a flexible touch mat arranged along this touch detection region of the steering wheel, and the flexible touch mat is provided with a touch detection sensor (for example, which is strip-shaped, fitted along the steering wheel, and able to sense touch at any position of the touch detection region), and measurement ends of the touch detection sensor may be led out from the touch mat, respectively denoted PA1 and PB2, PA2 and PB2, and PA3 and PB3. Each measurement end can have a reference signal applied thereto, and outputs a touch detection signal modulated by the touch detection sensor. Each flexible touch mat also may redundantly perform touch detection, for example, a reference signal may be applied to two measurement ends of the touch mat at separate times, thereby obtaining two modulated touch detection signals corresponding to the reference signal from the two measurement ends at separate times. The way in which the touch detection regions shown in Fig. 1B are partitioned is merely illustrative; according to the actual situation, partitioning and the arrangement of touch detection sensors therein may be performed in other ways.

Optionally, the touch detection sensor may be a sensor which is capable of sensing a capacitance and/or resistance value. For example, a capacitance value sensed by the touch detection sensor changes due to touching.

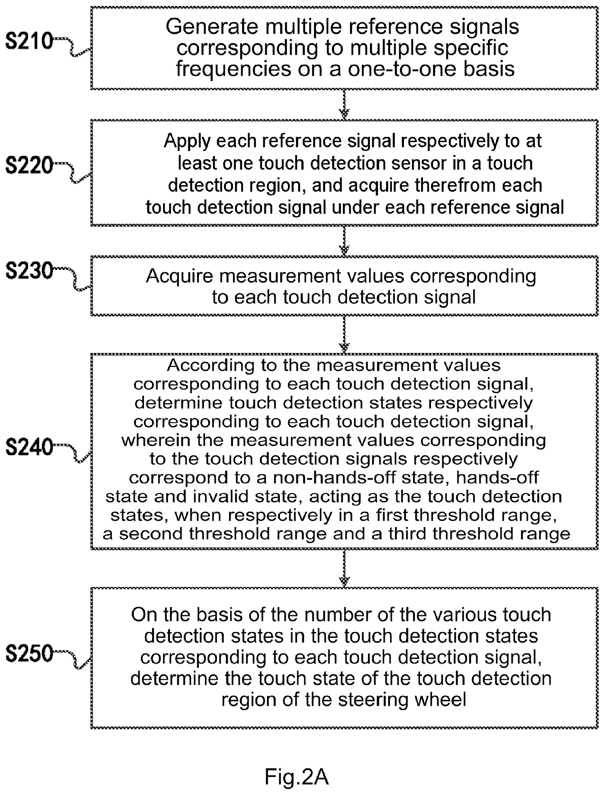

Fig. 2A shows an illustrative flowchart of a method 200 for steering wheel touch detection according to an embodiment of the present disclosure. Next, with reference to Fig. 2A, the process and steps of this steering wheel touch detection are explained in more detail.

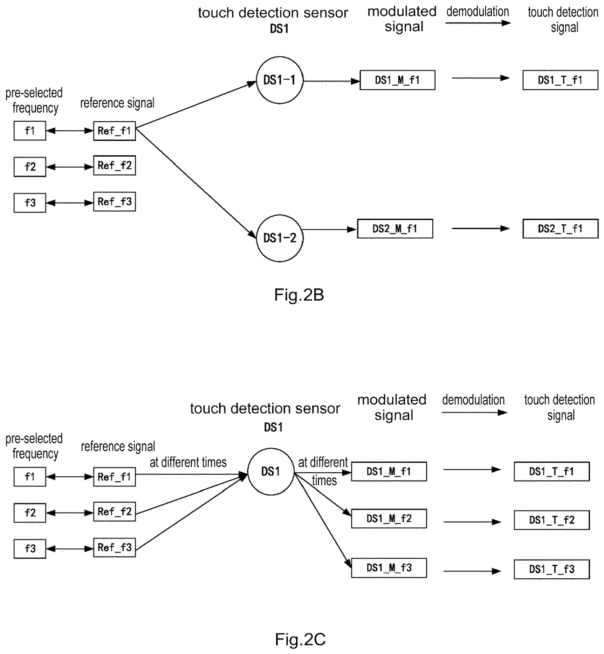

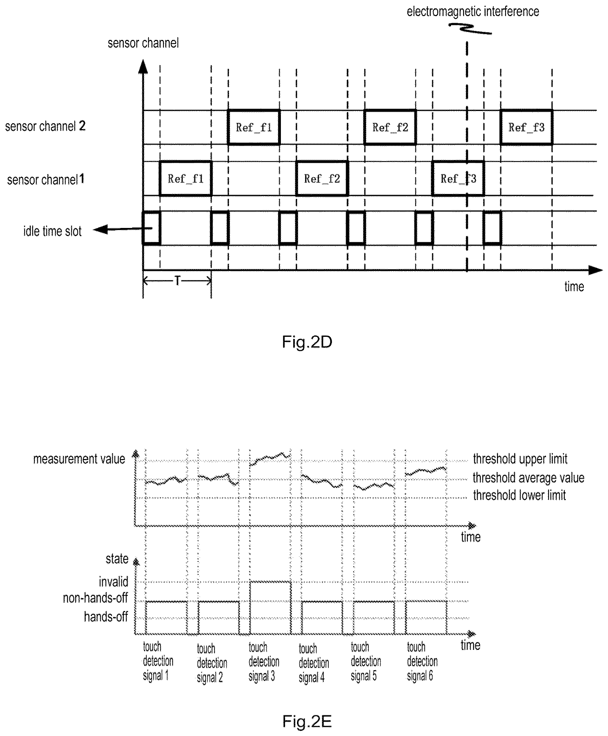

As described previously, the steering wheel is provided with a touch detection sensor which can detect touch on the steering wheel. In addition, the steering wheel may comprise multiple touch detection regions, and one touch detection sensor is used to detect touch for each touch detection region. In a situation in which redundancy is taken into account, at least two touch detection sensors (for example, multiple touch detection sensors arranged at specific positions as shown in Fig. 1A) are used to detect touch for each touch detection region. In a special example which achieves redundancy, as described previously, a touch detection sensor having two measurement ends may be provided in a flexible touch mat (for example, arranged along the steering wheel in region DB1 as shown in Fig. 1B); by means of applying a reference signal to the two measurement ends of the touch mat at separate times, two modulated touch detection signals related to the reference signal may be obtained from the two measurements ends at separate times; and at this time, the touch detection sensor having two measurement ends arranged in the flexible touch mat may also be understood as being equivalent to two redundant touch detection sensors provided in the touch detection region. At this time, the method described with reference to Fig. 2 may be applied to each touch detection region, that is, all the touch detection sensors in each touch detection region are jointly used for touch detection in this touch detection region.

In step S210, multiple reference signals corresponding to multiple specific frequencies on a one-to-one basis are generated.

In the touch detection process, if only a reference signal of a single specific frequency is used, the reference signal of this specific frequency and a touch detection signal generated by the reference signal may be affected by interference, such as electromagnetic interference, described previously, and therefore the touch detection result may not be accurate. Therefore, multiple reference signals of multiple specific frequencies may be generated, and, as described later, used for determining the touch state of the steering wheel, according to multiple touch detection signals generated on the basis of the multiple reference signals.

Optionally, each specific frequency in the multiple specific frequencies may be selected in sequence, and the reference signals corresponding to the selected specific frequencies are generated in sequence.

In step S220, with regard to each touch detection region, each reference signal in the multiple reference signals is respectively applied to the touch detection sensor in the touch detection region, and each touch detection signal under each reference signal is acquired from the touch detection sensor.

Optionally, with regard to each touch detection region, each reference signal in the multiple reference signals may be applied to the touch detection sensor in the touch detection region without temporal overlap (wherein the touch detection sensor modulates the reference signal applied thereto to generate a corresponding modulated touch detection signal (which may also be abbreviated to modulated signal)); and the modulated touch detection signal under each reference signal in the multiple reference signals is acquired from the touch detection sensor.

In order to more clearly understand the above content, the schematic drawing of the process progression of steps S210 and S220 is illustratively described below with reference to Fig. 2B. Fig. 2C shows a timing schematic drawing of the reference signals in Fig. 2B applied to a touch detection sensor without temporal overlap.

For example, with reference to Fig. 2B, with regard to a touch detection region on the steering wheel, 3 frequencies f1, f2 and f3 are selected to act as specific frequencies, and two touch detection sensors DS 1-1 and DS 1-2 are provided on the touch detection region, each sensor DS1-1 or DS1-2 corresponds to a touch detection channel (DS1-1 corresponds to sensor channel 1, and DS1-2 corresponds to sensor channel 2), and thus 2 sensor channels are formed. Alternatively, a touch detection sensor having two measurement ends is provided on the touch detection region, and each measurement end corresponds to a touch detection channel, thus also forming 2 sensor channels.

It should be noted that here a touch detection region on a steering wheel being provided with two touch detection sensors or a touch detection sensor having two measurement ends is merely illustratively explained, and of course, as described previously, for example with reference to Fig. 1B, according to actual requirements, the steering wheel may be partitioned into multiple touch detection regions, and each touch detection region may be provided with at least two touch detection sensors for design redundancy. Alternatively, each touch detection region may only be provided with a touch detection sensor of single-end measurement, that is, the touch detection sensor of each touch detection region only provides one touch detection signal. The present disclosure does not impose any limitations in this respect. For each touch detection region, sensor channels corresponding to each touch detection sensor on a one-to-one basis may be present.

In step S210 mentioned above, firstly, reference signals Ref_f1, Ref_f2 and Ref_f3 in one-to-one correspondence with the three pre-selected frequencies f1, f2 and f3 are generated, and thereafter, each reference signal of the reference signals Ref_f1, Ref_f2 and Ref_f3 is applied, without temporal overlap, to two redundant touch detection sensors DS1-1 and DS1-2 (which may also be understood as two measurement ends of one touch detection sensor, similarly below), and Fig. 2C shows a timing schematic drawing of applying the reference signals Ref_f1 - Ref_f3, without temporal overlap, to sensor channels 1 and 2 corresponding to the redundant two touch detection sensors DS1-1 and DS1-2. With reference to Fig. 2C, for example, firstly the reference signal Ref_f1 may be applied to the sensor channels 1 and 2 in sequence in time in signal action periods of period T, wherein the signal action period internally comprises an idle time slot (i.e. a time slot of signal inaction) and a signal action time slot (i.e. a time slot of the reference signal being continuously applied). Next, the reference signals Ref_f2 and Ref_f3 are applied to the sensor channels 1 and 2 in the same manner, wherein the reference signal Ref_f3, for example, is contaminated by the effects of electromagnetic interference in the environment. Next, each touch detection sensor modulates the reference signal applied thereto to generate a corresponding modulated touch detection signal (also abbreviated to modulated signal in the present disclosure); Fig. 2B shows the process of the touch detection sensors DS1-1 and DS 1-2 adjusting the reference signal Ref_f1, wherein the sensor DS 1-1 generates a modulated signal DS1_M_f1 corresponding to the reference signal Ref_f1, the sensor DS1_2 generates a modulated signal DS2_M_f1 corresponding to the reference signal Ref_f1, and the sensor DS1_2 generates a modulated signal DS2_M_f1 corresponding to the reference signal Ref_f1. Next, the modulated signal generated by each touch detection sensor is detected and the modulated signal is demodulated, to obtain a touch detection signal of each touch detection sensor under this reference signal. For example, taking reference signal Ref_f1, after modulated signals under reference signal Ref_f1 of the redundant two sensors DS1-1 and DS 1-2 are demodulated, touch detection signals of the redundant two sensors DS1-1 and DS1-2 corresponding to reference signal Ref_f1 may be obtained: DS1_T_f1 and DS2_T_f1.

Obviously, if more than two touch detection sensors are provided in a touch detection region on a steering wheel, for example, in the situation shown in Fig. 1A, n touch detection sensors (DS11... DS1n) are present in a touch detection region DA1, where n is an integer greater than 2, then n sensor channels may be arranged in the touch detection region DA1, and, similar to the process in Fig. 2B, a reference signal at each frequency is sequentially and periodically applied to each touch detection sensor by means of the sensor channels in order.

If a touch detection sensor DS1 of single-end-measurement is provided in a touch detection region on a steering wheel, then just 1 sensor channel may be provided, and a reference signal at each frequency is sequentially and periodically applied at different times to the touch detection sensor DS1 by means of the sensor channel, as shown in Fig. 2C.

In step S230, a measurement value of each touch detection signal is acquired.

Optionally, the measurement value of the touch detection signal comprises a capacitance value and/or resistance value, and therefore step S230 may comprise: demodulating each modulated touch detection signal, to obtain each capacitance value and/or resistance value sensed by the touch detection sensor.

For example, after each touch detection signal is obtained after demodulating each modulated touch detection signal, an electrical parameter (for example, the amplitude of the signal) of each touch detection signal may be measured to obtain a parameter value of each touch detection signal, and then, on the basis of a correspondence between the parameter value and a capacitance value and/or resistance value (for example, by means of querying a table or function relationship), a corresponding capacitance value and/or resistance value may be obtained from the parameter value.

Generally, in a situation in which the touch detection sensor works normally, for example in a situation in which it does not experience electromagnetic interference or interference is relatively low, for the same touch actions, even if reference signals at different frequencies are applied to the touch detection sensor at different times, and the touch detection sensor generates different modulated touch detection signals (modulated signals) at different times, a measurement value of each touch detection signal obtained on the basis of the different modulated signals obtained from the same touch detection sensor should be substantially the same; for example, each capacitance value obtained by means of respectively demodulating different modulated signals should be substantially the same (that is, fluctuating within a relatively small capacitance value threshold range). For example, for a touch action of a driver gripping the steering wheel with both hands, frequencies of 10 kHz and 20 kHz are respectively applied to the touch detection sensor, and a first modulated signal modulated at 10 kHz and a second modulated signal modulated at 20 kHz are respectively acquired, the first modulated signal and second modulated signal are respectively demodulated at 10 kHz and 20 kHz, so as to obtain two measurement values respectively corresponding to the first modulated signal and the second modulated signal, and the two measurement values should be substantially the same.

Optionally, a capacitance sensor may be used to act as a touch detection sensor to perform steering wheel touch detection, wherein the number of capacitance sensors is selected according to the number of touch detection regions on the steering wheel and whether the touch detection sensor of each detection region is designed with redundancy. Here, for each touch detection sensor, carrier signals (reference signals) at each specific frequency of a periodic signal having a variable amplitude, such as a sinusoidal wave, square wave or triangular wave, are sequentially applied to the touch detection sensor. For each carrier signal (reference signal), when the driver's hand touches or leaves the steering wheel, the touch detection sensors modulate the carrier signal to obtain a carrier modulated signal, to act as a modulated touch detection signal corresponding to the carrier signal, and, when the driver's hand touches the steering wheel, it causes a change in the capacitance sensed by the touch detection sensor, and therefore, when the hand touches or leaves the steering wheel, the modulated touch detection signal is different; then, by means of correspondingly demodulating the modulated touch detection signal under the carrier signal, the measurement value of the touch detection signal under the carrier signal may be derived, that is, the capacitance value sensed by the touch detection sensor (capacitance sensor) may be derived.

Optionally, a capacitance sensor using IQ modulation is used to act as a touch detection sensor to perform steering wheel touch detection. Here, for each touch detection sensor, carrier signals (reference signals) of a periodic signal having a variable amplitude, such as a sinusoidal wave, square wave or triangular wave, are sequentially applied to the touch detection sensor. For each carrier signal (reference signal), when the driver's hand touches or leaves the steering wheel, the touch detection sensors perform IQ modulation on the carrier signal to obtain a carrier modulated signal, to act as a modulated touch detection signal corresponding to the carrier signal, and, when the driver's hand touches or leaves the steering wheel, the modulated touch detection signal is different; and then, by means of performing corresponding IQ demodulation on the modulated touch detection signal under the carrier signal, not only can a capacitance value (Q component) sensed by the touch detection sensor (capacitance sensor) under the carrier signal be derived, but also a resistance value (I component) sensed by the touch detection sensor under the carrier signal can be derived, and, according to actual requirements, at least one of the capacitance value (Q component) and resistance value (I component) of the capacitance sensor is selected to act as a measurement value of the touch detection signal. If the measurement value of the touch detection signal is a capacitance value, then the capacitance value when touch has occurred increases; and if the measurement value of the touch detection signal is a resistance value, then the resistance value when touch has occurred decreases.

In step S240, touch detection states respectively corresponding to each touch detection signal are determined according to a measurement value of each touch detection signal, wherein the measurement values of the touch detection signals respectively correspond to a non-hands-off state (touch state), hands-off state (non-touch state) and invalid state, acting as the touch detection states, when respectively in a first threshold range, a second threshold range and a third threshold range.

In the following, taking as an example the case where the measurement values of the touch detection signals are capacitance values, in a situation in which the touch detection sensor is a capacitance sensor, the capacitance sensor, in a situation in which touching does not occur, still has a capacitance which may be called a baseline capacitance value, and, when the driver's hand touches the steering wheel, it introduces a new capacitance, and therefore, in a normal situation, each capacitance value sensed by the touch detection sensor under each reference frequency is enlarged compared to when there is no touching, and thus correspondingly a measurement value of each touch detection signal (modulated by the touch detection sensor) is also enlarged compared to when there is no touching. In addition, if the touch detection sensor experiences a fault, or experiences relatively severe electromagnetic interference at a certain frequency or certain frequencies, it is possible that a measurement value of each touch detection signal under reference signals of some frequencies exceeds a normal range (generally being too large), and, at this time, the touch detection signals whose measurement values exceed the normal range are invalid, and are not used for determining the touch state of the steering wheel. The measurement value may be an average value of measurement values of touch detection signals obtained by demodulation in a sampling period.

For example, in a situation in which touch has not occurred, a measurement value of the touch detection signal generated by the touch detection sensor fluctuates within a certain comparatively smaller value range, and, when a driver's hand touches the steering wheel (or a certain touch detection region thereof), the measurement value of the touch detection signal generated by the touch detection sensor (in the touch detection region) changes, so as to fall into another larger value range, and additionally, due, for example, to the touch detection sensor being faulty or interference, such as electromagnetic interference, being excessive, it is possible that a measurement value of a touch detection signal resulting from demodulation of a modulated signal generated by the touch detection sensor is outside both aforementioned ranges. Therefore, the touch detection state indicated by the touch detection signal may be determined according to the measurement value of each touch detection signal.

In some embodiments, each measurement value range for determining the touch detection states of the touch detection signals, described above, may be determined by means of demarcating measurement values of the touch detection signals generated by the touch detection sensor, when a person's hand and steering wheel are at a minimum distance position, and when the person's hand and steering wheel are at a maximum distance position.

The person's hand and steering wheel being at the minimum distance position is, for example, the position of the person's hand relative to the steering wheel when the person's hand is fully placed on the steering wheel; the person's hand and steering wheel being at the maximum distance position is, for example, the position of the person's hand relative to the steering wheel when the person's hand is completely off the steering wheel. It should be understood that the embodiments of the present disclosure are not restricted by the specific position settings of the minimum distance position and maximum distance position.

For example, when the person's hand and steering wheel are at the minimum distance position, a measurement value (for example, a capacitance value) of a touch detection signal generated by the touch detection sensor in this situation is recorded, and serves as a largest recorded value in a threshold range of measurement values of the corresponding touch detection signal when touch occurs; when the person's hand and steering wheel are at the maximum distance position, a measurement value of the touch detection signal in this situation is recorded, and serves as a smallest recorded value in a threshold range of measurement values of the touch detection signal. Next, on the basis of the largest recorded value and smallest recorded value, three threshold ranges are obtained, wherein if a measurement value of the touch detection signal is between 0 and the smallest recorded value (greater than or equal to 0, and less than or equal to the smallest recorded value), then it is determined that the touch detection state corresponding to the touch detection signal is a hands-off state (a non-touch state); if a measurement value of the touch detection signal is between the largest recorded value and the smallest recorded value (greater than the smallest recorded value, and less than or equal to the largest recorded value), then it is determined that the touch detection state corresponding to the touch detection signal is a non-hands-off state (a touch state); and if the measurement value of the touch detection signal exceeds the largest recorded value (greater than the largest recorded value), then it is determined that the touch detection state corresponding to the touch detection signal is an invalid state.

That is, a first threshold range, a second threshold range and a third threshold range may be set, and the measurement values of the touch detection signals respectively correspond to the non-hands-off (touch) state, hands-off (non-touch) state and invalid state (three types of touch detection state) when respectively in the first threshold range, second threshold range and third threshold range. By means of comparing the measurement value of each touch detection signal with the first threshold range, second threshold range and third threshold range, it is determined into which threshold range the measurement value of each touch detection signal falls, and thereby the touch detection states respectively corresponding to each touch detection signal are determined. Preferably, each threshold range may be set before a reference signal is applied to the touch detection sensor, thereby ensuring the touch detection process proceeds smoothly.

Optionally, a threshold lower limit of the first threshold range is equal to a threshold upper limit of the second threshold range, and a threshold lower limit of the third threshold range is equal to a threshold upper limit of the first threshold range. However, this is merely illustrative, and, on the basis of the selected measurement value type (capacitance value or resistance value), different demodulation means and/or different signal measurement means, the three threshold ranges may be set in different ways.

For example, in a situation in which a measurement value of the touch detection signal is a resistance value, when touching occurs, compared with when there is no touching, a measurement value (a resistance value) of the touch detection signal should become small; therefore, the threshold upper limit of the second threshold range corresponding to the non-hands-off state should be equal to the threshold lower limit of the first threshold range corresponding to the hands-off state. Moreover, the third threshold range corresponding to the invalid state may be a range formed by any other values not included in the first threshold range and the second threshold range, and may be set according to faults which need to be taken into account.

For example, Fig. 2E shows a schematic drawing of a correspondence between measurement values (taking capacitance values as an example) of touch detection signals and touch detection states. As shown in Fig. 2E, corresponding touch detection states are respectively determined according to measurement values corresponding to six touch detection signals 1-6, wherein the six touch detection signals may be generated by the illustrative processes shown in Figs. 2B and 2D, that is, reference signals of three specific frequencies are respectively applied in sequence to two touch detection sensors in one touch detection region (or a situation of two measurement ends of one touch detection sensor in a flexible touch mat), each touch detection sensor generates a modulated signal corresponding to the three reference signals, to acquire three touch detection signals after demodulation, and a total of six touch detection signals are therefore obtained.

In the example shown in Fig. 2E, the average values of the measurement values corresponding to touch detection signals 1 - 2 and 4 - 6 in a sampling time slot are all between a threshold upper limit and threshold lower limit of a threshold range (the first threshold range mentioned previously) corresponding to the non-hands-off state, and therefore the corresponding touch detection state is the non-hands-off state, and the average value of the measurement values corresponding to the touch detection signal 3 in a sampling time slot is greater than a threshold upper limit of a threshold range corresponding to the non-hands-off state (that is, a threshold lower limit of the threshold range (the third threshold range mentioned previously) corresponding to the invalid state), and therefore the corresponding touch detection state is the invalid state.

On the basis of the above, a threshold range is generated by means of demarcating measurement values of touch detection signals when a person's hand and the steering wheel are at the minimum distance position and the person's hand and the steering wheel are at the maximum distance position, enabling the generated threshold range to accurately correspond to the touch state and relative position of the person's hand and steering wheel; this is beneficial for increasing the precision of the touch detection state corresponding to the touch detection signal determined on the basis of the threshold range, and further, is beneficial for precision of the method for steering wheel touch detection which is subsequently implemented on the basis of these touch detection states.

In step S250, on the basis of the number of the various touch detection states in the touch detection states corresponding to each touch detection signal, the touch state of the touch detection region of the steering wheel is determined, the touch states comprising a non-hands-off (touch) state, a hands-off (non-touch) state and an invalid state.

In some situations, after the touch detection states corresponding to each touch detection signal under each reference signal is obtained, if the determined touch detection states corresponding to each touch detection signal are all valid (non-hands-off or hands-off) and consistent (all are non-hands-off or all are hands-off), then the touch state of the touch detection region of the steering wheel may be determined as the non-hands-off (touch) state, hands-off (non-touch) state or invalid state, and this type of method can increase the accuracy of judgment results and thereby increase safety.

However, as described previously, a touch detection sensor of a touch detection region experiences electromagnetic interference at a certain frequency or certain frequencies, and thus it is possible that, under reference signals of some frequencies, there are touch detection signals acquired from the touch detection sensor which are invalid, or it is possible that the touch detection states corresponding to each touch detection signal are inconsistent; therefore, by means of the above-described method, it is possible to directly judge that interference or a fault exists, and thus judgment of the touch state of the touch detection region is not performed on the steering wheel; it can be seen that the method has zero tolerance for touch detection signals which have been interfered with, and thus perhaps has a problem of excessively high safety, such that it is not possible to accurately determine the touch state of the touch detection region of the steering wheel. Therefore, the present disclosure further proposes a voting mechanism, so as to determine a touch state of a steering wheel on the basis of each touch detection state corresponding to each touch detection signal under each reference signal.

The principle of the voting mechanism used in the present disclosure may be summarised: there should be sufficiently many valid votes, then valid votes of various types among the valid votes are counted, and, according to a relationship between the proportion of the number of valid votes in the various types to the total number of votes and a preset proportion corresponding to each type, a final voting result is determined.

The determination of the touch state of the steering wheel on the basis of the voting mechanism is described in detail below.

By means of the method for determining a touch state of a steering wheel described with reference to Figs. 2A - 2E, a touch detection sensor in each touch detection region may be caused, on the basis of reference signals of different frequencies, to generate touch detection signals at each frequency, to improve the capability of steering wheel touch detection to resist electromagnetic interference in the usage environment; a touch detection signal may be acquired from at least two touch detection sensors which are redundantly designed, thereby improving redundancy; and on the basis of a voting mechanism, voting is performed on touch detection states indicated by each touch detection signal of the touch detection sensors, thereby determining the touch state of the steering wheel, so as to further improve the accuracy and flexibility of touch detection, therefore effectively reducing the influence of electromagnetic interference in the environment on the steering wheel touch detection process, improving the precision and robustness of steering wheel touch detection, and having good flexibility and reliability.

The above has described a method for determining the touch state of a steering wheel with reference to Figs. 2A - 2E; the below further describes the method in detail.

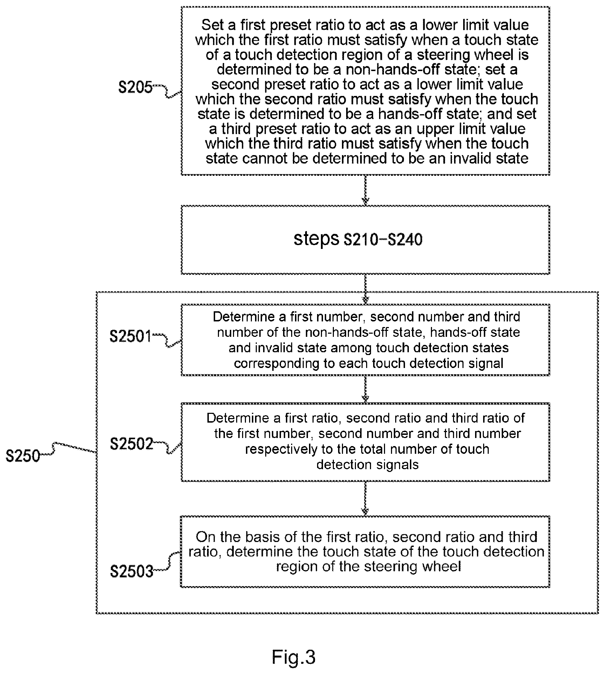

Fig. 3 shows more details of the above-mentioned method for determining the touch state of a steering wheel.

As shown in Fig. 3, step S250 (on the basis of the number of various touch detection states in the touch detection states corresponding to each touch detection signal, determining the touch state of the steering wheel) may comprise the following sub-steps.

In step S2501, a first number, second number and third number of a non-hands-off state, hands-off state and invalid state among touch detection states corresponding to each touch detection signal may be determined.

For example, the total number of touch detection signals is M, and the above-mentioned first number, second number and third number are respectively expressed as m, n and p.

For example, if X redundant touch detection sensors are arranged in one touch detection region, where X is an integer greater than or equal to 2, and N reference signals are applied to each touch detection sensor, then the total number of touch detection signals is M = X * N.

In step S2502, a first ratio, second ratio and third ratio of the first number, second number and third number respectively to the total number of touch detection signals are determined.

In step S2503, the touch state of the steering wheel is determined according to the first ratio, second ratio and third ratio.

It is necessary to compare each ratio with a preset ratio, so as to determine the touch state of the steering wheel, and therefore method 200 should further comprise a preset ratio setting step before said step S250, preferably before applying a reference signal to the touch detection sensor, so as to ensure the touch detection process proceeds smoothly.

As shown in Fig. 3, in step S205, a first preset ratio may be set to act as a lower limit value which the first ratio must satisfy when the touch state of the steering wheel is determined to be the non-hands-off state; a second preset ratio is set to act as a lower limit value which the second ratio must satisfy when the touch state of the steering wheel is determined to be the hands-off state; and the third preset ratio is set to act as an upper limit value which the third ratio must satisfy when the touch state of the steering wheel cannot be determined to be the invalid state.

More specifically, in a situation in which the first ratio is between the first preset ratio and 1, and the third ratio is between 0 and the third preset ratio, the touch state of the steering wheel is determined to be the non-hands-off state; and in a situation in which the first ratio is not between the first preset ratio and 1, and the second ratio is between the second preset ratio and 1, and the third ratio is between 0 and the third preset ratio, the touch state of the steering wheel is determined to be the hands-off state; and in other situations regarding the first ratio, second ratio and third ratio, the touch state of the steering wheel is determined to be the invalid state.

According to the safety level, each preset ratio may be set flexibly, so as to use each touch detection state corresponding to each touch detection signal. For example, the first preset ratio and second preset ratio may be 45%, and the third preset ratio may be 10%. Different values for the first preset ratio, second preset ratio and third preset ratio may be set according to actual situations.

By means of the method for determining the touch state of a steering wheel described with reference to Fig. 3, on the basis of the voting mechanism, the final determination of the touch state of the steering wheel is performed on the basis of each touch detection state corresponding to each touch detection signal acquired, which as well as being able to reduce the influence of electromagnetic interference etc. on touch detection, also may further increase the accuracy and flexibility of touch detection; for example, each preset ratio for judging the touch state of the steering wheel may be set flexibly according to safety level.

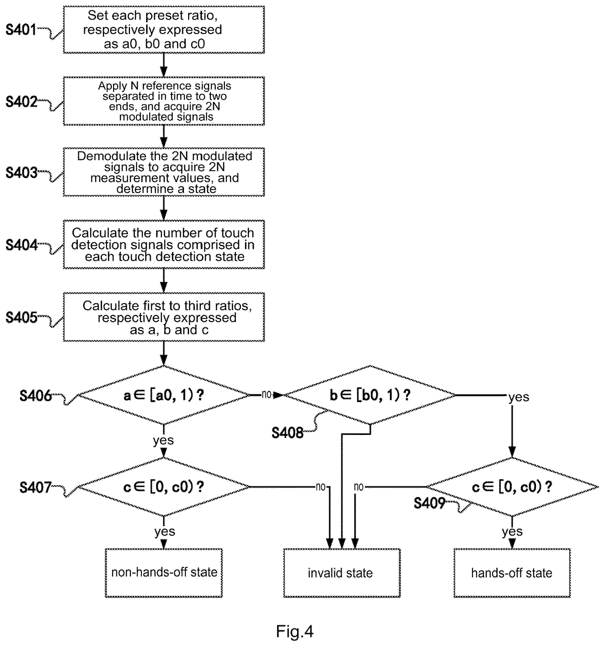

A specific illustrative flowchart of a method for steering wheel touch detection according to an embodiment of the present disclosure is described below with reference to Fig. 4, to better assist in understanding the principle of the present disclosure.

As described above, when measurement values of touch detection signals are located in different threshold ranges, they correspond to different touch detection states (as shown in Fig. 2E). The first ratio is a ratio of the number of touch detection signals for which the touch detection state corresponding thereto is the non-hands-off state to the total number of touch detection signals, the second ratio is a ratio of the number of touch detection signals for which the touch detection state corresponding thereto is the hands-off state to the total number of touch detection signals, and the third ratio is a ratio of the number of touch detection signals for which the touch detection state corresponding thereto is the invalid state to the total number of touch detection signals. In the example shown in Fig. 4, it is supposed that N reference signals of specific frequencies are generated, and two redundant touch detection sensors (or one touch detection sensor having two measurement ends) are arranged in one touch detection region of the steering wheel. In the example shown in Fig. 4, for this touch detection region, the N reference signals of specific frequencies are applied in sequence to the two touch detection sensors without temporal overlap, and 2N touch detection signals under the N reference signals are acquired from each one of the two touch detection sensors.

In step S401, each preset ratio is set.

For example, a first preset ratio a0 is set to act as a lower limit value which the first ratio must satisfy when the touch state of the steering wheel is determined to be the non-hands-off state; a second preset ratio b0 is set to act as a lower limit value which the second ratio must satisfy when the touch state of the steering wheel is determined to be the hands-off state; and a third preset ratio c0 is set to act as an upper limit value which the third ratio must satisfy when the touch state of the steering wheel cannot be determined as the invalid state. That is, if the touch state of the steering wheel is the non-hands-off state, then the first ratio is necessarily greater than or equal to the first preset ratio a0 and the third ratio is necessarily less than the third preset ratio, and if the touch state of the steering wheel is the hands-off state, then the first ratio is necessarily greater than or equal to the second preset ratio b0 and the third ratio is necessarily less than the third preset ratio.

In step S402, the N reference signals of specific frequencies are applied in sequence to the two touch detection sensors without temporal overlap, and 2N modulated touch detection signals (modulated signals) under the N reference signals are acquired from the two touch detection sensors. N is an integer greater than or equal to 2, preferably greater than or equal to 3.

In step S403, by means of demodulating the 2N modulated touch detection signals, 2N measurement values of the 2N touch detection signals are respectively obtained, and the touch detection states respectively corresponding to the 2N touch detection signals are determined on the basis of these measurement values.

In step S404, the number of touch detection signals comprised in each touch detection state is calculated, and m, n and p are respectively used to express the number of touch detection signals of the non-hands-off state, hands-off state and invalid state.

In step S405, a first ratio (a = m/2N), a second ratio (b = n/2N) and a third ratio (c = p/2N) are calculated.

In step S406, it is judged whether the first ratio a is between the first preset ratio a0 and 1 (that is, whether greater than or equal to a0, and less than or equal to 1), and if so, then step S407 is proceeded with, if not, then step S408 is proceeded with.

In step S407, it is judged whether the third ratio c is between the third preset ratio 0 and c0 (that is, whether greater than or equal to 0, and less than c0), and if so, then it is determined that the touch state of the touch detection region of the steering wheel is the non-hands-off state, if not, then it is determined that the touch state of the touch detection region of the steering wheel is the invalid state.

In step S408, it is judged whether the second ratio b is between the second preset ratio b0 and 1 (that is, whether greater than or equal to b0, and less than or equal to 1), and if so, then step S409 is proceeded with, if not, then it is determined that the touch state of the touch detection region of the steering wheel is the invalid state.

In step S409, it is judged whether the third ratio is between the third preset ratio 0 and c0 (that is, whether greater than or equal to 0, and less than c0), and if so, then it is determined that the touch state of the touch detection region of the steering wheel is the hands-off state, if not, then it is determined that the touch state of the touch detection region of the steering wheel is the invalid state.

By means of the method for determining a touch state of a steering wheel described with reference to Fig. 4, a touch detection sensor in each touch detection region may be caused, on the basis of reference signals of different frequencies, to generate touch detection signals at each frequency, to improve the capability of steering wheel touch detection to resist electromagnetic interference in the usage environment; for each touch detection region on the steering wheel, a touch detection signal may be acquired from at least two touch detection sensors (or one touch detection sensor having two measurement ends) which are redundantly designed, thereby improving redundancy; and on the basis of a voting mechanism, voting is performed on touch detection states indicated by each touch detection signal of the touch detection sensors in the touch detection region, thereby determining the touch state of the touch detection region of the steering wheel, so as to further improve the accuracy and flexibility of touch detection, therefore effectively reducing the influence of electromagnetic interference in the environment on the steering wheel touch detection process, improving the precision and robustness of steering wheel touch detection, and having good flexibility and reliability.

According to another aspect of the present disclosure, an apparatus for steering wheel touch detection is further disclosed. The steering wheel comprises at least one touch detection region, and each touch detection region is provided with at least one touch detection sensor which can detect touch on the steering wheel.

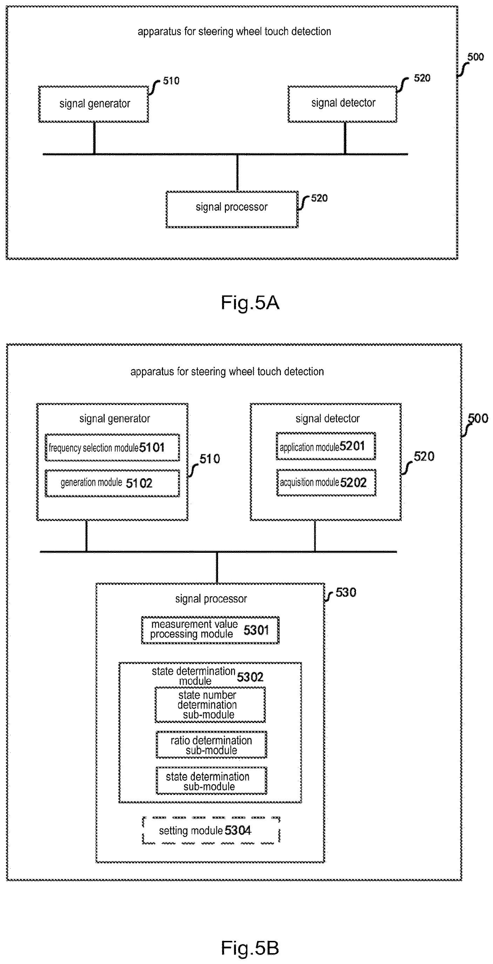

Figs. 5A - 5B show illustrative block diagrams of an apparatus 500 for steering wheel touch detection according to embodiments of the present disclosure.

Referring to Fig. 5A, the apparatus 500 for steering touch detection comprises: a signal generator 510, a signal detector 520 and a signal processor 530.

The signal generator 510 is configured to generate multiple reference signals corresponding to multiple specific frequencies on a one-to-one basis.

The signal detector 520 is configured, for each touch detection region, to apply each reference signal in the multiple reference signals respectively to the touch detection sensor in the touch detection region, and acquire each touch detection signal under each reference signal from the touch detection sensor.

The signal processor 530 is configured to: calculate a measurement value of each touch detection signal; according to the measurement value of each touch detection signal, determine the touch detection state respectively corresponding to each touch detection signal, wherein the measurement values of the touch detection signals respectively correspond to a non-hands-off state, a hands-off state and an invalid state, acting as the touch detection states, when respectively in a first threshold range, a second threshold range and a third threshold range; and on the basis of the number of each touch detection state corresponding to each touch detection signal, determine the touch state of the touch detection region of the steering wheel, the touch states comprising the non-hands-off state, the hands-off state and the invalid state.

In some embodiments, as shown in Fig. 5B, the signal generator 510 may comprise a frequency selection module 5101 and a generation module 5102. The frequency selection module 5101 is configured to sequentially select each specific frequency from multiple specific frequencies, and the generation module 5102 is configured to generate reference signals corresponding to the selected specific frequencies.

The signal detector 520 may comprise an application module 5201 and an acquisition module 5202. The application module 5201 is configured to acquire reference signals of multiple frequencies from the signal generator 510, and apply each reference signal in the multiple reference signals to the touch detection sensor in the touch detection region without temporal overlap, wherein the touch detection sensor modulates the reference signals applied thereto, to generate corresponding modulated touch detection signals. The acquisition module 5202 is further configured to acquire, from the touch detection sensor in the touch detection region, each modulated touch detection signal under each reference signal in the multiple reference signals.

In some embodiments, for design with redundancy, it is possible that at least two touch detection sensors, or one touch detection sensor having two measurement ends, are arranged in a touch detection region of the steering wheel. In this type of situation, the application module 5201 is further configured, for each reference signal in the multiple reference signals, to respectively apply the reference signals, separated in time, to at least two touch detection sensors, or two measurement ends of said one touch detection sensor having two measurement ends, in this touch detection region, and the acquisition module 5202 is further configured, for each reference signal in the multiple reference signals, to acquire each touch detection signal under the reference signal from the at least two touch detection sensors or each measurement end of said one touch detection sensor having two measurement ends.

In addition, the signal processor 530 may comprise a measurement value processing module 5301 and a state determination module 5302. The measurement value processing module 5301 may be configured to acquire a measurement value of each touch detection signal, and determine touch detection states respectively corresponding to each touch detection signal according to the measurement value of each touch detection signal, wherein the measurement values of the touch detection signals respectively correspond to a non-hands-off state, hands-off state and invalid state, acting as the touch detection states, when respectively in a first threshold range, a second threshold range and a third threshold range. For the determination of each threshold range, the specific description of step S230 of method 200 may be referred to above. In an embodiment of the present disclosure, the measurement value acquisition module 5301 may comprise a demodulation sub-module, configured to demodulate (for example, by IQ demodulation) each touch detection signal which has been modulated, to obtain each capacitance value and/or resistance value, sensed by the touch detection sensor, to act as measurement values.

The state determination module 5303 may be configured to determine the touch state of the touch detection region of the steering wheel, on the basis of the number of various touch detection states corresponding to each touch detection signal, the touch states comprising a non-hands-off state, a hands-off state and an invalid state.

More specifically, the state determination module 5302 may further comprise: a state number determination sub-module, a ratio determination sub-module and a state determination sub-module. The state number determination module is configured to determine a first number, second number and third number of a non-hands-off state, hands-off state and invalid state among steering wheel touch states corresponding to each touch detection signal; the ratio determination sub-module is configured to determine a first ratio, second ratio and third ratio of the first number, second number and third number respectively to the total number of touch detection signals; and the state determination sub-module is configured to determine the touch state of the touch detection region of the steering wheel, on the basis of the first ratio, second ratio and third ratio.

The method of the state determination sub-module determining the touch state of the touch detection region of the steering wheel may more specifically comprise: in a situation in which the first ratio is between the first preset ratio and 1, and the third ratio is between 0 and the third preset ratio, the touch state is determined to be the non-hands-off state; and in a situation in which the first ratio is not between the first preset ratio and 1, the second ratio is between the second preset ratio and 1, and the third ratio is between 0 and the third preset ratio, the touch state is determined to be the hands-off state; and in other situations regarding the first ratio, second ratio and third ratio, the touch state is determined to be the invalid state.

Correspondingly, the signal processor 530 further may comprise a setting module 5304, used for setting values of the first preset ratio, second preset ratio and third preset ratio to be used by the state determination module. For example, a first preset ratio is set to act as a lower limit value which the first ratio must satisfy when the touch state of the touch detection region of the steering wheel is determined to be the non-hands-off state; a second preset ratio is set to act as a lower limit value which the second ratio must satisfy when the touch state of the touch detection region of the steering wheel is determined to be the hands-off state; and the third preset ratio is set to act as an upper limit value which the third ratio must satisfy when the touch state of the touch detection region of the steering wheel cannot be determined as the invalid state.

Each module of the apparatus 500 for steering wheel touch detection has been described above with reference to Figs. 5A - 5B, and reference may be made to earlier descriptions for more details on the operations of each module. In addition, according to actual requirements, more or fewer components and modules may be added into the apparatus 500.

In some specific applications, the apparatus 500 also may be viewed as a combination of a controller and sensor system. For example, the sensor system may be used for implementing the functions of the signal generator, the signal detector, and the measurement value processing module in the signal processor described with reference to Figs. 5A - 5B, and then the controller may be used for implementing the functions of the state determination module and setting module described with reference to Figs. 5A - 5B; for example, each touch detection signal which has been demodulated is acquired from the sensor system, and then, on the basis of the voting mechanism, determination of the touch state of the steering wheel is performed for these demodulated touch detection signals. The controller may be, for example, computational logic having processing functions, such as a micro control unit (MCU) and a digital signal processor (DSP).

By means of the apparatus for determining a touch state of a steering wheel described with reference to Figs. 5A - 5B, a touch detection sensor in each touch detection region may be caused, on the basis of reference signals of different frequencies, to generate touch detection signals at each frequency, to improve the capability of steering wheel touch detection to resist electromagnetic interference in the usage environment; a touch detection signal may be acquired from at least two touch detection sensors (or one touch detection sensor having two measurement ends) which are redundantly designed, thereby improving redundancy; and on the basis of a voting mechanism, voting is performed on touch detection states indicated by each touch detection signal of the touch detection sensors, thereby determining the touch state of the touch detection region of the steering wheel, so as to further improve the accuracy and flexibility of touch detection, therefore effectively reducing the influence of electromagnetic interference in the environment on the steering wheel touch detection process, improving the precision and robustness of steering wheel touch detection, and having good flexibility and reliability.

Although various specific exemplary embodiments of the present subject matter have been described in detail, each example is provided by way of explaining rather than restricting the present disclosure. After those skilled in the art have gained an understanding of the above-described content, they could easily alter, change or make equivalents of such embodiments. Therefore, the present invention does not rule out including such modifications, changes and/or additions to the present subject matter which would be obvious to those skilled in the art. For example, some of the illustrated or described features acting as one embodiment can be used with another embodiment to produce a further embodiment. Therefore, the intention is that the present disclosure covers such alterations, changes and equivalents.

It must be explained that the flow charts and block diagrams in the figures show an implementable system architecture, functions and operations of a system, method and functional modules according to embodiments of the present disclosure. On this point, each box in the flowcharts or block diagrams may represent a module, procedure segment or part of code, the module, procedure segment or part of code including at least one executable instruction for implementing a fixed logic function. It should also be noted that, in some alternative implementations, the functions marked in the boxes may also occur in a different order to that marked in the figures. For example, two boxes shown in succession may actually be substantially executed in parallel, and sometimes they may also be executed in the reverse order: it depends on the functions involved. It should also be noted that each box in the block diagrams and/or flowcharts, and the combination of boxes in the block diagrams and/or flowcharts may be implemented by a dedicated hardware-based system which executes fixed functions or operations, or may be implemented by a combination of dedicated hardware and computer instructions.

The exemplary embodiments of the present disclosure described in detail above are merely descriptive, and not restrictive. Those skilled in the art should understand that various modifications and combinations may be made to these embodiments or features thereof without departing from the principles and spirit of the present disclosure, and such modifications shall fall within the scope of the present disclosure.

## Claims

1. A method for steering wheel touch detection, wherein the steering wheel comprises at least one touch detection region, and at least one touch detection sensor is provided in each touch detection region, and the method comprises: for each touch detection region,
generating multiple reference signals corresponding to multiple specific frequencies on a one-to-one basis;
applying each reference signal in the multiple reference signals respectively to the touch detection sensor in the touch detection region, and acquiring each touch detection signal under each reference signal from the touch detection sensor;
acquiring a measurement value of each touch detection signal;
determining touch detection states respectively corresponding to each touch detection signal, according to the measurement value of each touch detection signal, wherein the measurement values of the touch detection signals respectively correspond to a non-hands-off state, hands-off state and invalid state, acting as touch detection states, when respectively in a first threshold range, a second threshold range and a third threshold range; and
on the basis of the number of the various touch detection states in the touch detection states corresponding to each touch detection signal, determining the touch state of the touch detection region of the steering wheel, the touch states comprising the non-hands-off state, hands-off state and invalid state.

2. The method as claimed in claim 1, wherein the step of applying each reference signal in the multiple reference signals respectively to the touch detection sensor in the touch detection region, and acquiring each touch detection signal under each reference signal from the touch detection sensor, comprises:
applying each reference signal in the multiple reference signals to the touch detection sensor in the touch detection region without temporal overlap, wherein the touch detection sensor modulates the reference signals applied thereto, to generate corresponding modulated touch detection signals; and
acquiring from the touch detection sensor the modulated touch detection signals under each reference signal in the multiple reference signals.

3. The method as claimed in claim 2, wherein the touch detection region comprises at least two touch detection sensors, or one touch detection sensor having two measurement ends,
wherein the step of applying each reference signal in the multiple reference signals respectively to the touch detection sensor, and acquiring each touch detection signal under each reference signal from the touch detection sensor in the touch detection region, comprises: for each reference signal in the multiple reference signals,
respectively applying the reference signals separated in time to the at least two touch detection sensors, or to the two measurement ends of said one touch detection sensor having two measurement ends, and
acquiring the touch detection signals under the reference signals from each touch detection sensor of the at least two touch detection sensors, or each measurement end of said one touch detection sensor having two measurement ends.

4. The method as claimed in any one of claims 1 - 3, wherein the step of determining the touch state of the touch detection region of the steering wheel, on the basis of the number of the various touch detection states in the touch detection states corresponding to each touch detection signal, comprises:
determining a first number, second number and third number of the non-hands-off state, hands-off state and invalid state among the touch detection states corresponding to each touch detection signal;
determining a first ratio, second ratio and third ratio of the first number, second number and third number respectively to the total number of touch detection signals; and
on the basis of the first ratio, second ratio and third ratio, determining the touch state of the touch detection region of the steering wheel.

5. The method as claimed in claim 4, further comprising:
setting a first preset ratio to act as a lower limit value which the first ratio must satisfy when the touch state of the touch detection region of the steering wheel is determined to be the non-hands-off state;
setting a second preset ratio to act as a lower limit value which the second ratio must satisfy when the touch state of the touch detection region of the steering wheel is determined to be the hands-off state; and
setting a third preset ratio to act as an upper limit value which the third ratio must satisfy when the touch state of the touch detection region of the steering wheel cannot be determined to be the invalid state.

6. The method as claimed in claim 5, wherein the step of determining the touch state of the touch detection region of the steering wheel, on the basis of the first ratio, second ratio and third ratio, comprises:
in a situation in which the first ratio is between the first preset ratio and 1, and the third ratio is between 0 and the third preset ratio, determining the touch state to be the non-hands-off state; and
in a situation in which the first ratio is not between the first preset ratio and 1, and the second ratio is between the second preset ratio and 1, and the third ratio is between 0 and the third preset ratio, determining the touch state to be the hands-off state; and
in other situations regarding the first ratio, second ratio and third ratio, determining the touch state to be the invalid state.

7. The method as claimed in claim 1, wherein the step of generating multiple reference signals corresponding to multiple specific frequencies on a one-to-one basis comprises:
sequentially selecting each specific frequency in the multiple specific frequencies, and generating reference signals corresponding to the selected specific frequencies.

8. The method as claimed in claim 3, wherein the measurement value of the touch detection signal comprises a capacitance value and/or resistance value, wherein the step of acquiring the measurement value of each touch detection signal comprises:
performing IQ demodulation on each touch detection signal which has been modulated, to acquire each capacitance value and/or resistance value sensed by the touch detection sensor in the touch detection region.

9. The method as claimed in claim 1, wherein the measurement value of the touch detection signal comprises a capacitance value,
a threshold lower limit of the first threshold range is equal to a threshold upper limit of the second threshold range; and
a threshold lower limit of the third threshold range is equal to a threshold upper limit of the first threshold range.

10. The method as claimed in claim 1, wherein at least one touch detection sensor in each touch detection region is jointly used for detecting the touch state of the touch detection region of the steering wheel.

11. An apparatus for steering wheel touch detection, wherein the steering wheel comprises at least one touch detection region, and each touch detection region is provided with at least one touch detection sensor which can detect touch on the steering wheel, the apparatus comprising:
a signal generator, which is configured to generate multiple reference signals corresponding to multiple specific frequencies on a one-to-one basis;
a signal detector, which is configured, for each touch detection region, to apply each reference signal in the multiple reference signals respectively to the touch detection sensor in the touch detection region, and acquire each touch detection signal under each reference signal from the touch detection sensor; and
a signal processor, which is configured:
to acquire a measurement value of each touch detection signal;
to determine touch detection states respectively corresponding to each touch detection signal, according to the measurement value of each touch detection signal, wherein the measurement values of the touch detection signals respectively correspond to a non-hands-off state, hands-off state and invalid state, acting as the touch detection states, when respectively in a first threshold range, a second threshold range and a third threshold range; and
on the basis of the number of the various touch detection states corresponding to each touch detection signal, to determine the touch state of the touch detection region of the steering wheel, the touch states comprising the non-hands-off state, hands-off state and invalid state.

12. The apparatus as claimed in claim 11, wherein the signal detector comprises:
an application module, which is configured to apply each reference signal in the multiple reference signals to the touch detection sensor in the touch detection region without temporal overlap, wherein the touch detection sensor modulates the reference signals applied thereto, to generate corresponding modulated touch detection signals; and
an acquisition module, which is configured to acquire, from the touch detection sensor in the touch detection region, each modulated touch detection signal under each reference signal in the multiple reference signals.

13. The apparatus as claimed in claim 12, wherein the touch detection region comprises at least two touch detection sensors, or one touch detection sensor having two measurement ends,
the application module is further configured, for each reference signal in the multiple reference signals, to respectively apply the reference signals separated in time to the at least two touch detection sensors, or to the two measurement ends of said one touch detection sensor having two measurement ends, in the touch detection region, and
the acquisition module is further configured, for each reference signal in the multiple reference signals, to acquire the touch detection signals under the reference signals from each touch detection sensor of the at least two touch detection sensors, or each measurement end of said one touch detection sensor having two measurement ends.

14. The apparatus as claimed in any one of claims 11 - 13, wherein the signal processor comprises: a measurement value processing module and a state determination module;
the measurement value processing module is used for acquiring the measurement value of each touch detection signal, and, according to the measurement value of each touch detection signal, determining the touch detection states respectively corresponding to each touch detection signal,
the state determination module comprises:
a state number determination sub-module, which is configured to determine a first number, second number and third number of the non-hands-off state, hands-off state and invalid state among the steering wheel touch states corresponding to each touch detection signal;
a ratio determination sub-module, which is configured to determine a first ratio, second ratio and third ratio of the first number, second number and third number respectively to the total number of touch detection signals; and
a state determination sub-module, which is configured to determine the touch state of the touch detection region of the steering wheel, on the basis of the first ratio, second ratio and third ratio.

15. The apparatus as claimed in claim 14, the signal processor further comprising a setting module, which is configured to:
set a first preset ratio to act as a lower limit value which the first ratio must satisfy when the touch state of the touch detection region of the steering wheel is determined to be the non-hands-off state;
set a second preset ratio to act as a lower limit value which the second ratio must satisfy when the touch state of the touch detection region of the steering wheel is determined to be the hands-off state; and
set a third preset ratio to act as an upper limit value which the third ratio must satisfy when the touch state of the touch detection region of the steering wheel cannot be determined to be the invalid state.

16. The apparatus as claimed in claim 15, wherein the state determination sub-module is configured to determine the touch state of the touch detection region of the steering wheel in the following way:
in a situation in which the first ratio is between the first preset ratio and 1, and the third ratio is between 0 and the third preset ratio, determining the touch state to be the non-hands-off state; and
in a situation in which the first ratio is not between the first preset ratio and 1, and the second ratio is between the second preset ratio and 1, and the third ratio is between 0 and the third preset ratio, determining the touch state to be the hands-off state; and
in other situations regarding the first ratio, second ratio and third ratio, determining the touch state to be the invalid state.

17. The apparatus as claimed in claim 11, wherein the signal generator comprises:
a frequency selection module, which is configured to sequentially select each specific frequency from the multiple specific frequencies, and
a generation module, which is configured to generate reference signals corresponding to the selected specific frequencies.

18. The apparatus as claimed in claim 14, wherein the measurement value of the touch detection signal comprises a capacitance value and/or resistance value,
wherein the measurement value processing module further comprises a demodulation sub-module, which is configured to:
perform IQ demodulation on each touch detection signal which has been modulated, to acquire each capacitance value and/or resistance value sensed by the touch detection sensor.

19. The apparatus as claimed in claim 11, wherein the measurement value of the touch detection signal comprises a capacitance value,
a threshold lower limit of the first threshold range is equal to a threshold upper limit of the second threshold range; and
a threshold lower limit of the third threshold range is equal to a threshold upper limit of the first threshold range.

20. The apparatus as claimed in claim 11, wherein at least one touch detection sensor in each touch detection region is jointly used for detecting the touch state of the touch detection region of the steering wheel.
